# EUROPEAN PATENT APPLICATION

(11) **EP 4 626 161 A1**
(43) Date of publication of application: **01.10.2025**
(21) Application number: 24770535.3
(22) Date of filing: 28.02.2024
(51) Int. Cl.: H05K 7/20, H02M 3/00, H02M 7/48

(54) **POWER SUPPLY MODULE**

(30) Priority: 14.03.2023 JP 2023039978
(71) Applicant: AISIN CORPORATION, Kariya-shi, Aichi 448-8650 (JP)
(72) Inventor: SUGIMOTO Noriaki, Kariya-shi, Aichi 448-8650 (JP); KATSUDA Takuya, Kariya-shi, Aichi 448-8650 (JP); SUYAMA Daiki, Kariya-shi, Aichi 448-8650 (JP); YOSHIMURA Shinya, Kariya-shi, Aichi 448-8650 (JP); NAGAI Yuki, Kariya-shi, Aichi 448-8650 (JP); HIRAYAMA Hirokazu, Kariya-shi, Aichi 448-8650 (JP); KOASHI Hidefumi, Kariya-shi, Aichi 448-8650 (JP); TAKEMOTO Keisuke, Kariya-shi, Aichi 448-8650 (JP); MUTSUURA Keita, Kariya-shi, Aichi 448-8650 (JP); GOTO Kenta, Kariya-shi, Aichi 448-8650 (JP)
(74) Representative: Kramer Barske Schmidtchen Patentanwälte PartG mbB
(86) International application number: PCT/JP2024/007393
(87) International publication number: WO 2024/190424

(57) **Abstract**

A power supply module includes a cooling case facing a plurality of electronic components that generate different amounts of heat. The cooling case is provided inside with a channel through which a cooling fluid flows. The cooling case includes a first portion facing the electronic component that generates a relatively large amount of heat, and a second portion facing the electronic component that generates a relatively small amount of heat. The second portion has a lower thermal conductivity than the first portion.

## Description

### TECHNICAL FIELD

The present disclosure relates to power supply modules.

### BACKGROUND ART

A power supply module is conventionally known in which an electronic circuit such as a converter circuit and a control board that controls the electronic circuit are housed in an upper case and a lower case that are separated by a cooling partition and a partition cover (see, for example, Patent Document 1). This power supply module is reduced in size by housing the electronic circuit and the control board in the same case.

In the power supply module described in Patent Document 1, a cooling channel formed by a cooling partition and a partition cover, both made of metal, is located inside a case body, and a cooling fluid flows through the cooling channel. The inside of the case body is divided into two spaces by the channel. The electronic circuit is housed in the space in the upper case, and the control board is housed in the space in the lower case.

### Related Art Documents

### Patent Documents

Patent Document 1: WO 2015/133201

### SUMMARY OF THE INVENTION

### Problem to be Solved by the Invention

The electronic circuit such as a converter circuit as described in Patent Document 1 includes a plurality of electronic components that generates different amounts of heat such as a capacitor, a reactor, a transformer, a high-voltage switching device, and a low-voltage switching device. These electronic components are arranged so as to be in thermal contact with the cooling partition or the partition cover. Therefore, the cooling fluid absorbs the heat generated by the plurality of electronic components and reduces an increase in temperature of the electronic components. Part of the heat absorbed by the cooling fluid is dissipated into the internal space of the case body from the surfaces of the cooling partition and the partition cover that are made of metal. In the power supply module described in Patent Document 1, the entire cooling partition and the entire partition cover are made of metal. Therefore, the cooling partition and the partition cover have high heat absorption efficiency in absorbing the heat generated by the electronic components, but at the same time, have high heat dissipation efficiency in dissipating the absorbed heat to the outside. Accordingly, there is room for improvement in order to use the heat absorbed by the cooling fluid for heating a vehicle cabin etc.

Therefore, there is a demand for a power supply module that allows the heat absorbed by a cooling fluid to be effectively used.

### Means for Solving the Problem

A characteristic configuration of a power supply module according to the present disclosure is that the power supply module includes a cooling case facing a plurality of electronic components that generates different amounts of heat, the cooling case is provided inside with a channel through which a cooling fluid flows, the cooling case includes a first portion facing the electronic component that generates a relatively large amount of heat and a second portion facing the electronic component that generates a relatively small amount of heat, and the second portion has a lower thermal conductivity than the first portion.

In this configuration, the electronic component that generates a relatively large amount of heat faces the first portion of the cooling case, and the electronic component that generates a relatively small amount of heat faces the second portion of the cooling case that has a lower thermal conductivity than the first portion. Accordingly, the heat generated by the electronic component that generates a relatively large amount of heat can be efficiently absorbed by the cooling fluid flowing through the channel inside the cooling case, and the temperature of the electronic component that generates a relatively large amount of heat can be reduced. Since the second portion is provided in the area where the electronic component that generates a relatively small amount of heat is in contact, the heat absorbed by the cooling fluid in the first portion is less likely to be dissipated to the outside from the second portion. The present disclosure can thus provide a power supply module that allows the heat absorbed by the cooling fluid in the first portion to be effectively used for heating a vehicle cabin etc.

### BRIEF DESCRIPTION OF THE DRAWINGS

[FIG. 1] FIG. 1 is a circuit configuration diagram of a cooling system including a power supply module according to a first embodiment.
[FIG. 2] FIG. 2 is an exploded perspective view of the power supply module.
[FIG. 3] FIG. 3 is a longitudinal section of the power supply module.
[FIG. 4] FIG. 4 is a sectional view taken along line IV-IV and viewed in the direction of the arrows in FIG. 2.
[FIG. 5] FIG. 5 is a longitudinal section of a power supply module according to a second embodiment.
[FIG. 6] FIG. 6 is a longitudinal section of a power supply module according to a third embodiment.

### MODES FOR CARRYING OUT THE INVENTION

Hereinafter, embodiments of a power supply module according to the present disclosure will be described in detail with reference to the drawings. The embodiments described below are merely examples illustrating the present disclosure, and the present disclosure is not limited to only these embodiments. Therefore, the present disclosure can be carried out in various forms without departing from the spirit and scope of the present disclosure.

### [Configuration of Cooling Circuit]

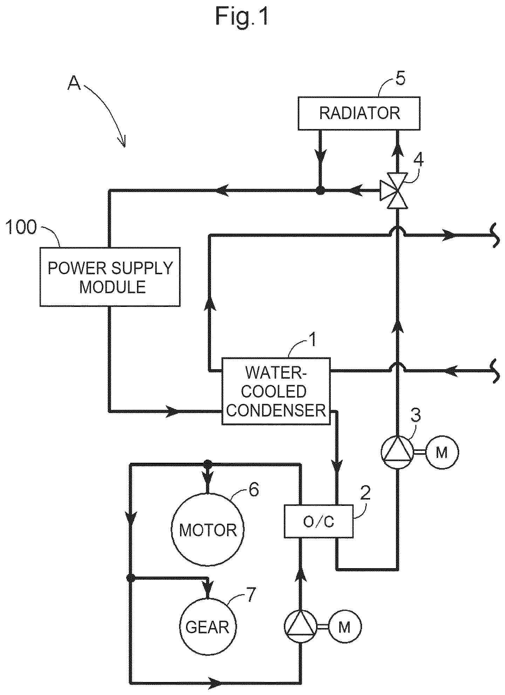

As shown in FIG. 1, a cooling circuit A including a power supply module 100 according to an embodiment cools the power supply module 100 with a cooling fluid. The cooling fluid is a coolant such as long-life coolant (LLC), insulating oil such as paraffin-based oil, or a refrigerant such as hydrofluorocarbon (HFC) or hydrofluoroolefin (HFO). In the present embodiment, it is preferable to use a liquid with high electrical insulation properties such as a coolant like long-life coolant (LLC) or a fluorine-based inert liquid. A cooling liquid containing a coolant or insulating oil may be used. The cooling circuit A is mounted on a vehicle that charges a battery (not shown) with external power.

The cooling circuit A includes the power supply module 100, a water-cooled condenser 1, an oil cooler 2, a water pump 3, a three-way valve 4, and a radiator 5. After the cooling fluid heated by cooling the power supply module 100 flows out of the power supply module 100, the cooling fluid is heated by heat exchange with a cooling medium in the water-cooled condenser 1 and is then further heated by heat exchange with lubricating oil in the oil cooler 2. The lubricating oil cooled in the oil cooler 2 cools a motor 6 and a gear mechanism 7. The heated cooling fluid is pumped by the water pump 3 and switched by the three-way valve 4 between being sent to the radiator 5 and not being sent to the radiator 5. When the cooling fluid is sent to the radiator 5, the cooling fluid is cooled by the radiator 5 and flows back into the power supply module 100. When the cooling fluid is not sent to the radiator 5, the heated cooling fluid flows back into the power supply module 100 without being cooled.

### [First Embodiment]

### [Configuration of Power Supply Module]

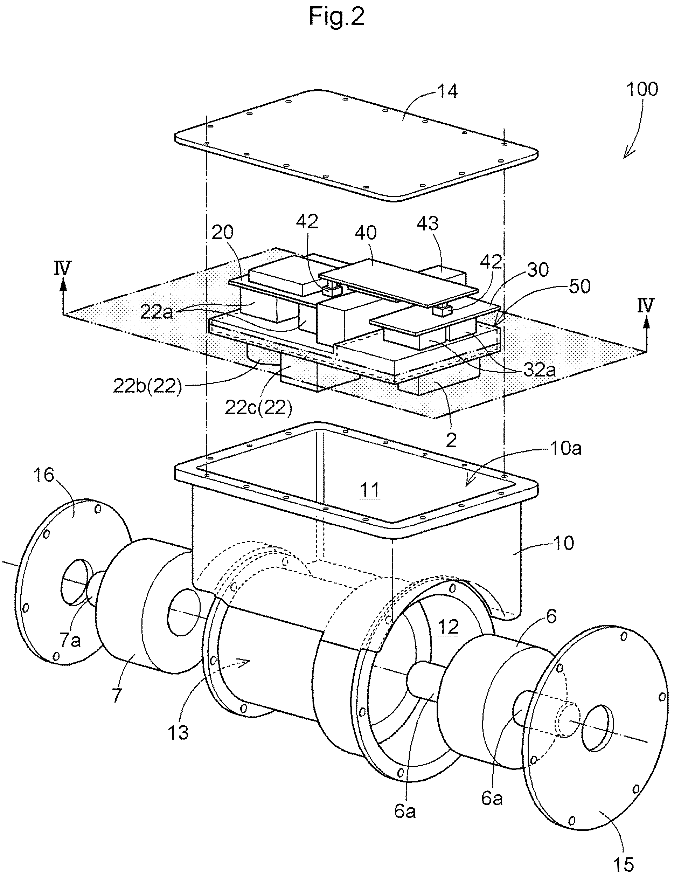

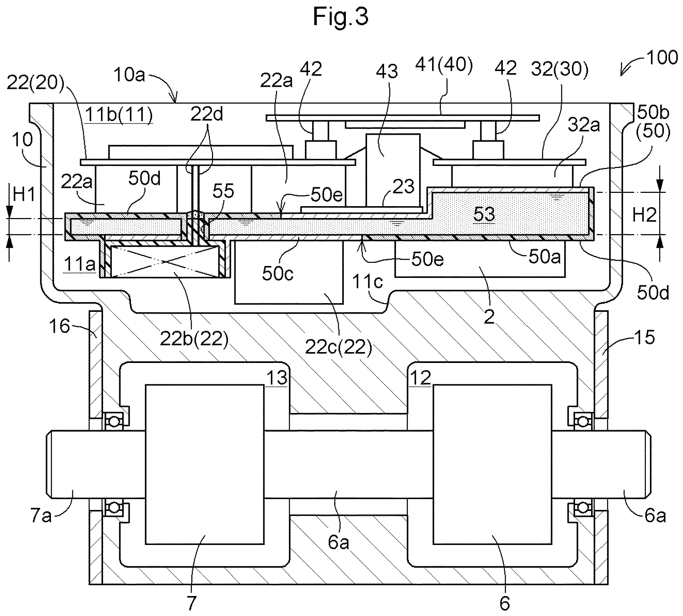

As shown in FIG. 2, the power supply module 100 according to the first embodiment is formed by housing, in a housing 10, at least an OBC (On Board Charger) board 20 (an example of the drive board), a motor drive board 30 (an example of the drive board), and a control board 40 that controls the OBC board 20 and the motor drive board 30. The power supply module 100 has a first space 11. The OBC board 20, the motor drive board 30, and the control board 40 are separate boards and are housed in the first space 11 in attitudes parallel to each other. FIG. 3 shows a section taken along a direction perpendicular to a board surface of the OBC board 20 (motor drive board 30, control board 40). Hereinafter, the direction perpendicular to the board surface of the OBC board 20 will be referred to as "vertical direction." A direction in which the control board 40 is viewed from the OBC board 20 and the motor drive board 30 along the vertical direction in FIG. 3 will be referred to as "upward direction," "upper side," etc., and the direction in which the OBC board 20 and the motor drive board 30 are viewed from the control board 40 along the vertical direction in FIG. 3 will be referred to as "downward direction," "lower side," etc.

The housing 10 has a second space 12 and a third space 13 that are separated from the first space 11. The second space 12 and the third space 13 are located below the first space 11. The motor 6 that is driven by the motor drive board 30 is housed in the second space 12, and the gear mechanism 7 that reduces the rotational speed of the motor 6 and outputs the resultant rotation is housed in the third space 13. The housing 10 has an opening 10a on the upper side of the first space 11, and the OBC board 20, the motor drive board 30, the control board 40, and a cooling case 50 are placed into the first space 11 from the opening 10a. The opening 10a is closed by a lid 14 (see FIG. 2). The first space 11 is therefore a closed space. The motor 6 is placed into the second space 12 from the side. The second space 12 is a closed space closed by a motor cover 15 fastened with bolts, not shown. Motor shafts 6a extend from both sides of the motor 6 along its rotational axis. One of the motor shafts 6a extends through the motor cover 15 and is exposed to the outside of the housing 10. The other motor shaft 6a extends into the third space 13. The gear mechanism 7 is placed into the third space 13 from the side. The third space 13 is a closed space closed by a gear cover 16 fastened with bolts (not shown). The other motor shaft 6a extending from the second space 12 is connected to the gear mechanism 7, and rotation of the motor 6 is input to the gear mechanism 7 via the motor shaft 6a. The gear mechanism 7 reduces the rotational speed of the motor 6 and outputs the resultant rotation from a gear shaft 7a. The gear shaft 7a extends through the gear cover 16 and is exposed to the outside of the housing 10.

A power converter 22 (an example of the electronic circuit) is mounted on the OBC board 20. The power converter 22 includes at least an AC-DC converter that converts an externally input alternating current to a direct current and a DC-DC converter that converts a direct current voltage to a direct current voltage suitable for charging the battery, not shown. Since the configurations of AC-DC converters and DC-DC converters are known in the art, detailed description thereof will be omitted.

The AC-DC converter and the DC-DC converter of the power converter 22 include: a heat-generating component 22a (an example of the electronic component) that is an example of an electronic component that generates a relatively small amount of heat; and a reactor 22b (an example of the electronic component) and a transformer 22c (an example of the electronic component) that are examples of electronic components that generate a relatively large amount of heat. Examples of the heat-generating component 22a include a diode (an example of the electronic component) and a switching element (an example of the electronic component).

A power converter 32 (an example of the electronic circuit) is mounted on the motor drive board 30. The power converter 32 includes at least an inverter that controls a drive current for driving the motor 6. Since the configuration of inverters is known in the art, detailed description thereof will be omitted. A control circuit 41 that controls the power converter 22 and the power converter 32 is mounted on the control board 40.

The inverter of the power converter 32 includes a heat-generating component 32a (an example of the electronic component that generates a relatively large amount of heat). Examples of the heat-generating component 32a included in the power converter 32 include a diode (an example of the electronic component) and a switching device (an example of the electronic component). These electronic components have different heights.

In the present embodiment, the OBC board 20 and the motor drive board 30 are located at the same height in the vertical direction. The control board 40 is disposed so as to overlap with the OBC board 20 and the motor drive board 30 when viewed along the vertical direction (as viewed in the vertical direction). Board-to-board connectors 42 are used to connect the OBC board 20 and the control board 40 and to connect the motor drive board 30 and the control board 40. In the present embodiment, the OBC board 20 and the motor drive board 30 are located at the same height in the vertical direction. Therefore, two of the same type of board-to-board connectors 42 can be used to connect the OBC board 20 and the control board 40 and to connect the motor drive board 30 and the control board 40. This configuration facilitates mounting of the control board 40 to the OBC board 20 and the motor drive board 30, and also provides ease of assembly because there is no need to use different types of connectors.

### [Film Capacitor]

As described above, the OBC board 20 and the motor drive board 30 are separate boards. In the present embodiment, as shown in FIGS. 2 and 3, a film capacitor 43 (an example of the electronic component that generates a relatively large amount of heat) is disposed between the OBC board 20 and the motor drive board 30. The film capacitor 43 is used both for smoothing the inverter of the power converter 32 and for smoothing the secondary side of the DC-DC converter of the power converter 22. That is, the film capacitor 43 serves to perform two different kinds of smoothing.

The film capacitor 43 has a height from near an upper case 50b of the cooling case 50 to near the control board 40 in the vertical direction. That is, the film capacitor 43 has a greater height in the vertical direction than electronic components mounted on the OBC board 20, including the heat-generating component 22a, and electronic components mounted on the motor drive board 30, including the heat-generating component 32a. Therefore, the periphery of the motor drive board 30 is surrounded by the control board 40, the film capacitor 43, and a wall surface of the housing 10, and is separated from the periphery of the OBC board 20. This can reduce transfer of the heat generated by the power converter 32 of the motor drive board 30 to the OBC board 20.

### [Cooling Case]

The cooling case 50 that cools the heat-generating component 22a, the reactor 22b, and the transformer 22c of the power converter 22 and the heat-generating component 32a of the power converter 32 is housed in the first space 11 of the housing 10. The cooling case 50 according to the present embodiment is configured as an insert-molded part produced by insert-molding a material containing a metal with a high thermal conductivity such as aluminum into a material containing a resin with a lower thermal conductivity than metal. Hereinafter, a portion of the cooling case 50 that is made of the material containing a metal will be referred to as first portion 50c, and a portion of the cooling case 50 that is made of the material containing a resin will be referred to as second portion 50d. That is, the first portion 50c is higher in thermal conductivity, heat absorption efficiency, and heat dissipation efficiency than the second portion 50d. The boundary between the first portion 50c and the second portion 50d is a joint 50e. The cooling case 50 is formed as a single piece by joining a lower case 50a in the shape of a plate and the upper case 50b. The lower case 50a and the upper case 50b are both insert-molded parts, and each has the first portion 50c and the second portion 50d. The cooling case 50 has a space inside (between the lower case 50a and the upper case 50b), and the cooling fluid flows through this internal space.

As described above, the OBC board 20 and the motor drive board 30 are located at the same height in the vertical direction. In order to implement this, the power supply module 100 of the present embodiment includes a height adjustment mechanism. Specifically, the channel height H1 in the vertical direction of a portion facing the OBC board 20 (a portion that overlaps with the OBC board 20 as viewed in the vertical direction) is made different from the channel height H2 in the vertical direction of a portion facing the motor drive board 30 (a portion that overlaps with the motor drive board 30 as viewed in the vertical direction). In the present embodiment, the channel height H2 is greater than the channel height H1. That is, the height adjustment mechanism of the present embodiment is to make the channel heights H1, H2 of the cooling case 50 different from each other depending on the board that the cooling case 50 faces.

In the present embodiment, of the lower case 50a and the upper case 50b of the cooling case 50, the lower case 50a is in the shape of a flat plate, but the upper case 50b has different heights between the portion corresponding to the OBC board 20 and the portion corresponding to the motor drive board 30. Specifically, the portion of the upper case 50b that corresponds to the motor drive board 30 has a greater height from the lower case 50a than the portion of the upper case 50b that corresponds to the OBC board 20. As described above, the heat-generating component 22a used in the power converter 22 of the OBC board 20 and the heat-generating component 32a used in the power converter 32 of the motor drive board 30 are both cooled by contact with the upper case 50b of the cooling case 50. That is, the heat-generating component 22a of the power converter 22 has a great mounting height, while the heat-generating component 32a of the power converter 32 on the motor drive board 30 has a small mounting height.

Therefore, in the upper case 50b of the present embodiment, the channel height H2 is made greater than the channel height H1 by an amount corresponding to the difference between the mounting height of the heat-generating component 22a and the mounting height of the heat-generating component 32a. This allows the OBC board 20 and the motor drive board 30 to be aligned with each other at the same height in the vertical direction with both the tall heat-generating component 22a and the short heat-generating component 32a in contact with the upper case 50b.

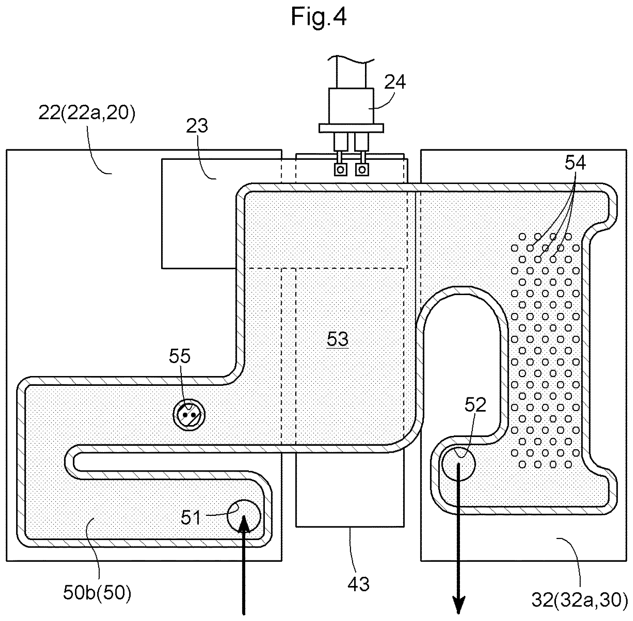

A channel 53 of the cooling case 50 is disposed as shown in FIG. 4 as viewed in the vertical direction. In the present embodiment, the cooling fluid flows into the cooling case 50 through an inlet 51 and flows out of the cooling case 50 through an outlet 52. The channel 53 has a plurality of protrusions 54 on the downstream side of the channel 53 that faces the heat-generating component 32a. The protrusions 54 are formed on either or both of the upper case 50b and the lower case 50a so as to protrude from the outside toward the inside to hinder the flow of the cooling fluid. The protrusions 54 have the shape of a spherical cap, and are arranged in a staggered pattern with respect to the flow direction of the cooling fluid. For example, when the protrusions 54 are arranged on the lower case 50a, the coolant near the lower case 50a is lifted toward the upper case 50b by the protrusions 54, creating a vortex. As a result, the cooling fluid near the upper case 50b and the cooling fluid near the lower case 50a are mixed together, and the coolant temperature near the upper case 50b can be reduced. The cooling fluid near the upper case 50b thus has a reduced temperature and can absorb more heat. Therefore, the temperature of the heat-generating component 32a can further be reduced.

As shown in FIGS. 3 and 4, a metal base substrate 23 (an example of the drive board) is disposed on the upper case 50b. The film capacitor 43 and a connection terminal 24 to which a direct current voltage from the battery, not shown, is input are attached to the metal base substrate 23.

**In** the present embodiment, as shown in FIG. 3, the first portion 50c is provided in the area where the reactor 22b, the transformer 22c, the heat-generating component 32a, and the film capacitor 43 that generate a relatively large amount of heat are in contact, and the second portion 50d is provided in the remaining area including the area where the heat-generating component 22a that generates a relatively small amount of heat is in contact. In the present embodiment, the film capacitor 43 is mounted in contact with the first portion 50c with the metal base substrate 23 therebetween, but the metal base substrate 23 has equivalent thermal conductivity to the first portion 50c. Therefore, the film capacitor 43 can be substantially considered to be in contact with the first portion 50c.

As described above, the reactor 22b, the transformer 22c, the heat-generating component 32a, and the film capacitor 43, namely the electronic components that generate a relatively large amount of heat, are in contact with the first portion 50c of the cooling case 50 that is made of a material with a high thermal conductivity, and exchange heat with the cooling fluid flowing through the internal space of the cooling case 50. The generated heat is thus efficiently absorbed by the cooling fluid, thereby reducing the temperatures of the reactor 22b, the transformer 22c, the heat-generating component 32a, and the film capacitor 43 and increasing the temperature of the cooling fluid. Since the second portion 50d is provided in the remaining area including the area where the heat-generating component 22a that generates a relatively small amount of heat is in contact, the heat absorbed by the cooling fluid in the first portion 50c is less likely to be dissipated to the outside from the second portion 50d. Therefore, the heat absorbed by the cooling fluid in the first portion 50c can be effectively used for heating a vehicle cabin etc. The heat-generating component 22a is in contact with the second portion 50d of the cooling case 50. However, since the heat-generating component 22a generates a small amount of heat, there is no issue even if the generated heat cannot be sufficiently absorbed by the cooling fluid.

### [Arrangement of Tall Electronic Components]

As shown in FIG. 3, the first space 11 is divided by the cooling case 50 into a first region 11a located below the cooling case 50 and a second region 11b located above the cooling case 50. In the present embodiment, the capacity of the first region 11a is smaller than the capacity of the second region 11b. In the first space 11, the plurality of electronic components of the power converter 22 (including the heat-generating component 22a) and the plurality of electronic components of the power converter 32 (including the heat-generating component 32a) are disposed in separate regions, namely the first region 11a and the second region 11b. The OBC board 20, the motor drive board 30, and the control board 40 are disposed in the second region 11b.

In the present embodiment, the reactor 22b and the transformer 22c of the power converter 22 and the oil cooler 2 are disposed in the first region 11a. The heat-generating component 22a of the power converter 22 and the heat-generating component 32a such as a diode or switching device of the power converter 32 are disposed in the second region 11b. The reactor 22b, the transformer 22c, and the oil cooler 2 that are disposed in the first region 11a are in contact with the lower case 50a of the cooling case 50, and the diodes and the switching elements that are disposed in the second region 11b are in contact with the upper case 50b. Among the electronic components, the electronic components with relatively large heights are housed and arranged in the first region 11a, and the electronic components with relatively small heights are housed and arranged in the second region 11b.

The first region 11a is adjacent to the second space 12 in which the motor 6 is disposed and the third space 13 in which the gear mechanism 7 is disposed, via a wall of the housing 10. That is, the first region 11a faces the motor 6 and the gear mechanism 7, with the wall of the housing 10 in between. The first region 11a has, in its portion facing the gear mechanism 7, a recess 11c recessed toward the third space 13. Therefore, the portion of the first region 11a where the recess 11c is formed has a greater height (depth) downward (toward the gear mechanism 7) from an imaginary reference plane (the lower case 50a of the cooling case 50).

Between the reactor 22b and the transformer 22c that are disposed in the first region 11a, the transformer 22c has a relatively greater height. Therefore, in the present embodiment, as shown in FIG. 3, the reactor 22b is disposed in the area that does not face the recess 11c, and the transformer 22c is disposed in the area that faces the recess 11c. The transformer 22c is disposed in such a manner that part of the transformer 22c is located in the recess 11c. By arranging the reactor 22b and the transformer 22c in this manner, the recess 11c in the first region 11a can be effectively used and the size of the power supply module 100 can be reduced.

### [Providing Insulation by Potting]

In the present embodiment, the reactor 22b and the transformer 22c are disposed in the first region 11a of the first space 11, the OBC board 20 is disposed in the second region 11b, and the first region 11a and the second region 11b are separated by the cooling case 50. A pair of lead wires 22d located at both ends of the coil winding of the reactor 22b needs to be electrically connected to the OBC board 20. Therefore, in the present embodiment, a through hole 55 is formed in the cooling case 50, and the lead wires 22d of the reactor 22b are passed through the through hole 55 and electrically connected to the OBC board 20. Although not described in the present embodiment, the same configuration is applicable to lead wires of the coil winding of the transformer 22c and other electronic components disposed in the first region 11a.

### [Effects of First Embodiment]

In the present embodiment, the reactor 22b, the transformer 22c, the heat-generating component 32a, and the film capacitor 43, namely the electronic components that generate a relatively large amount of heat, contact the first portion 50c of the cooling case 50 that is made of a material with a high thermal conductivity. Therefore, the generated heat can be efficiently absorbed by the cooling fluid, thereby reducing the temperatures of the reactor 22b, the transformer 22c, the heat-generating component 32a, and the film capacitor 43 and increasing the temperature of the cooling fluid. The second portion 50d is provided in the area other than the first portion 50c. This can reduce dissipation of the heat absorbed by the cooling fluid in the first portion 50c to the outside from the second portion 50d. Therefore, the heat absorbed by the cooling fluid in the first portion 50c can be effectively used for heating a vehicle cabin etc.

**In** the cooling case 50 of the present embodiment, the first portion 50c is made of a material containing metal, and the second portion 50d is made of a material containing resin. Therefore, there is a large difference in thermal conductivity between the first portion 50c and the second portion 50d. This can reduce dissipation of the heat absorbed by the cooling fluid in the first portion 50c to the outside from the second portion 50d.

**In** the present embodiment, the cooling case 50 (lower case 50a, upper case 50b) is produced by insert molding. This facilitates production of the cooling case 50 made of materials with different thermal conductivities.

### [Second Embodiment]

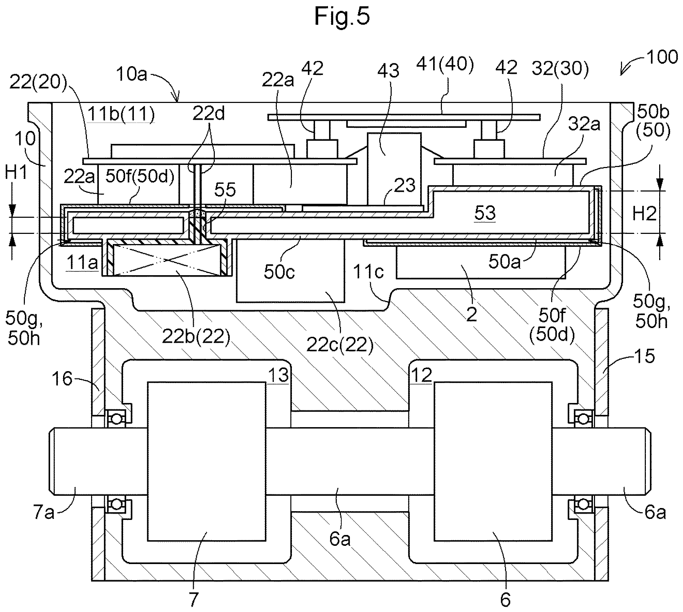

Next, the configuration of the power supply module 100 according to a second embodiment will be described with reference to FIG. 5. The present embodiment is different from the first embodiment in the configuration of the second portion 50d of the cooling case 50. The configuration of the present embodiment is otherwise the same as the first embodiment. Therefore, in the description of the present embodiment, the portions with the same configurations as in the first embodiment are denoted with the same signs, and detailed description of the same configurations will be omitted.

In the present embodiment, the second portion 50d of the cooling case 50 includes a plurality of layers (two layers in the present embodiment) with a gap 50g in between in which a gas is present. Specifically, the entire cooling case 50 according to the present embodiment is made of a material containing a metal with a high thermal conductivity such as aluminum. The portion of the lower case 50a in the shape of a plate and the portion of the upper case 50b that correspond to the second portion 50d are covered by a thermal insulation cover 50f made of a material containing a metal with a high thermal conductivity such as aluminum. There is the gap 50g between the thermal insulation cover 50f and the lower and upper cases 50a, 50b except for the outer edge of the thermal insulation cover 50f, and the gap 50g is a closed space. This closed space is filled with a gas having a lower thermal conductivity than metal such as air 50h (an example of the gas) or argon gas. The heat-generating component 22a and the oil cooler 2 are mounted in contact with the thermal insulation cover 50f.

As described above, the second portion 50d includes a plurality of layers with the gap 50g in between in which a gas having a lower thermal conductivity than metal is present. This can reduce dissipation of the heat absorbed by the cooling fluid in the first portion 50c to the outside from the second portion 50d, as in the first embodiment.

### [Third Embodiment]

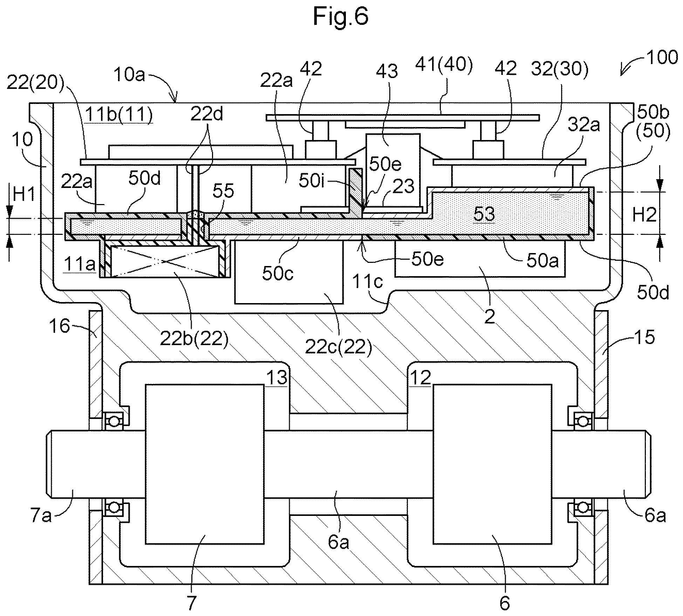

Next, the configuration of the power supply module 100 according to a third embodiment will be described with reference to FIG. 6. The present embodiment is different from the first embodiment in the configuration of the second portion 50d of the cooling case 50. The configuration of the present embodiment is otherwise the same as the first embodiment. Therefore, in the description of the present embodiment, the portions with the same configurations as in the first embodiment are denoted with the same signs, and detailed description of the same configurations will be omitted.

In the present embodiment, the second portion 50d of the cooling case 50 extends farther toward the film capacitor 43 than in the first embodiment in the area where the heat-generating component 22a that generates a relatively small amount of heat is in contact. The cooling case 50 includes, between the heat-generating component 22a and the film capacitor 43, a wall 50i standing from the cooling case 50. Like the second portion 50d, the wall 50i is made of a material containing resin. The wall 50i can be formed simultaneously with the formation of the second portion 50d by insert molding. However, the wall 50i may be formed separately from the second portion 50d and attached to the cooling case 50 by a method such as adhesion.

It is preferable that the area of the surface of the wall 50i that faces the heat-generating component 22a and the film capacitor 43 be larger than at least the smaller one of the area of the surface of the heat-generating component 22a that faces the wall 50i and the area of the surface of the film capacitor 43 that faces the wall 50i. It is more preferable that the area of the surface of the wall 50i that faces the heat-generating component 22a and the film capacitor 43 be larger than the larger one of the area of the surface of the heat-generating component 22a that faces the wall 50i and the area of the surface of the film capacitor 43 that faces the wall 50i.

Generally, electronic components that generate a relatively small amount of heat have lower heat resistance than electric components that generate a relatively large amount of heat. Therefore, when an electronic component that generates a relatively small amount of heat is disposed near an electronic component that generates a relatively large amount of heat, the electronic component that generates a relatively small amount of heat may be adversely affected by the heat generated by the electronic component that generates a relatively large amount of heat. However, by providing the wall 50i between the heat-generating component 22a that generates a relatively small amount of heat and the film capacitor 43 that generates a relatively large amount of heat as in the present embodiment, the heat-generating component 22a can be made less likely to be affected by the heat generated by the film capacitor 43.

### [Other Embodiments]

(1) **In** the above embodiments, the film capacitor 43 is mounted on the metal base substrate 23. However, the film capacitor 43 may be mounted in direct contact with the first portion 50c of the cooling case 50.
(2) In the above embodiments, the channel height of the cooling case 50 is different between the portion corresponding to the motor drive board 30 and the portion corresponding to the OBC board 20. However, these portions may have the same channel height. In this case, a common control board 40 can be used by varying the heights of the board-to-board connectors.
(3) In the second embodiment, the thermal insulation cover 50f is made of a material containing a metal with a high thermal conductivity such as aluminum. However, the thermal insulation cover 50f may be made of a material containing a resin with a lower thermal conductivity than metal.
(4) In the second embodiment, a closed space is created by the thermal insulation cover 50f and the closed space is filled with the air 50h, namely a gas having a lower thermal conductivity than metal. However, the present disclosure is not limited to this. For example, the thermal insulation cover 50f may be made of a plate made of a material containing a metal with a high thermal conductivity such as aluminum, and may be attached such that the gap 50g is provided between the thermal insulation cover 50f and the lower case 50a or the upper case 50b by ribs etc. In this case, the air 50h is present as a gas in the gap 50g.
(5) In the above embodiments, the joint 50e at the boundary between the first portion 50c and the second portion 50d is formed by insert-molding the first portion 50c into the second portion 50d. However, the second portion 50d may be outsert-molded onto the first portion 50c. The joint 50e may be formed by welding etc.
(6) The wall 50i in the third embodiment is provided for the configuration of the first embodiment. However, the wall 50i may be provided for the configuration of the second embodiment.

The following configurations are possible for the embodiments described above.

<1> A characteristic configuration of a power supply module (100) according to the present disclosure is that the power supply module includes a cooling case (50) facing a plurality of electronic components (22a, 22b, 22c, 32a, 43) that generates different amounts of heat, the cooling case is provided inside with a channel (53) through which a cooling fluid flows, the cooling case (50) includes a first portion (50c) facing the electronic component (22b, 22c, 32a, 43) that generates a relatively large amount of heat, and a second portion (50d) facing the electronic component (22a) that generates a relatively small amount of heat, and the second portion has a lower thermal conductivity than the first portion (50c).

In this configuration, the electronic component (22b, 22c, 32a, 43) that generates a relatively large amount of heat faces the first portion (50c) of the cooling case (50), and the electronic component (22a) that generates a relatively small amount of heat faces the second portion (50d) of the cooling case (50) that has a lower thermal conductivity than the first portion (50c). Accordingly, the heat generated by the electronic component (22b, 22c, 32a, 43) that generates a relatively large amount of heat can be efficiently absorbed by the cooling fluid flowing through the channel (53) inside the cooling case (50), and the temperature of the electronic component (22b, 22c, 32a, 43) that generates a relatively large amount of heat can be reduced. Since the second portion (50d) is provided in the area where the electronic component (22a) that generates a relatively small amount of heat is in contact, the heat absorbed by the cooling fluid in the first portion (50c) is less likely to be dissipated to the outside from the second portion (50d). The present disclosure can thus provide a power supply module (100) that allows the heat absorbed by the cooling fluid in the first portion (50c) to be effectively used for heating a vehicle cabin etc.

<2> In the power supply module (100) described in <1> above, it is preferable that the plurality of electronic components (22a, 22b, 22c, 32a) form an electronic circuit (22, 32), and that the electronic circuit (22, 32) be mounted on a drive board (20, 30).

In this configuration, the electronic circuit (22, 32) is mounted on the drive board (20, 30). Therefore, the size of the power supply module (100) can be reduced compared to a case where the electronic circuit (22, 32) is mounted on a different board from the drive board (20, 30).

<3> In the power supply module (100) described in <1> or <2> above, it is preferable that the electronic component that generates a relatively large amount of heat be at least one of a reactor (22b), a transformer (22c), and a film capacitor (43).

In this configuration, the electronic component that generates a relatively large amount of heat is at least one of the reactor (22b), the transformer (22c), and the film capacitor (43). In this case, the heat generated by these electronic components is efficiently absorbed by the cooling fluid flowing through the channel (53) inside the cooling case (50). The temperature of at least one electronic component among the reactor (22b), the transformer (22c), and the film capacitor (43) can thus be reduced.

<4> In the power supply module (100) described in any one of <1> to <3> above, it is preferable that the first portion (50c) be made of a material containing aluminum and that the second portion (50d) be made of a material containing resin.

In this configuration, the first portion (50c) is made of a material containing aluminum, and the second portion (50d) is made of a material containing resin. This can reduce dissipation of the heat absorbed by the cooling fluid in the first portion (50c) to the outside from the second portion (50d).

<5> In the power supply module (100) described in <4> above, it is preferable that a joint (50e) provided by insert-molding the first portion (50c) into the second portion (50d) be present at the boundary between the first portion (50c) and the second portion (50d).

The cooling case (50) having the first portion (50c) and the second portion (50d) can be formed by insert molding as in this configuration.

<6> In the power supply module (100) described in any one of <1> to <4> above, it is preferable that the second portion (50d) include a plurality of layers with a gap (50g) in between in which a gas (50h) having a lower thermal conductivity than the first portion (50c) is present.

As described above, the second portion (50d) includes a plurality of layers with the gap (50g) in between in which the gas (50h) having a lower thermal conductivity than the first portion (50c) is present. This can reduce dissipation of the heat absorbed by the cooling fluid in the first portion (50c) to the outside from the second portion (50d).

<7> In the power supply module (100) described in <6> above, it is preferable that the gas be air (50h).

In this configuration, by using air (50h) as the gas having a low thermal conductivity, the gap (50g) having a low thermal conductivity can be easily provided.

<8> In the power supply module (100) according to any one of <1> to <7> above, it is preferable that the channel (53) of the cooling case (50) include a plurality of protrusions (54).

In this configuration, the cooling fluid flowing through the cooling case (50) is lifted by the protrusions (54), creating a vortex. The cooling fluid is thus stirred, and the temperature of the cooling fluid can be reduced. Accordingly, the temperature of the electronic component (32a) that generates a relatively large amount of heat can further be reduced.

<9> In the power supply module (100) described in any one of <1> to <8> above, it is preferable that the cooling case (50) includes an upper case (50b) and a lower case (50a), and that the upper case (50b) or the lower case (50a) include the first portion (50c) and the second portion (50d).

In this configuration, the upper case (50b) or the lower case (50a) includes the first portion (50c) and the second portion (50d). This allows both the electronic component (22b, 22c, 32a, 43) that generates a relatively large amount of heat and the electronic component (22a) that generates a relatively small amount of heat to face the case including the first portion (50c) and the second portion (50d).

<10> In the power supply module (100) described in any one of <1> to <9> above, it is preferable that the cooling case (50) include, between the electronic component (43) that generates a relatively large amount of heat and the electronic component (22a) that generates a relatively small amount of heat, a wall (50i) made of a material contained in the second portion (50d).

In this configuration, the wall (50i) is provided between the electronic component (22a) that generates a relatively small amount of heat and the electronic component (43) that generates a relatively large amount of heat. Therefore, the electronic component (22a) that generates a relatively small amount of heat can be made less likely to be affected by the heat generated by the electronic component (43) that generates a relatively large amount of heat.

### INDUSTRIAL APPLICABILITY

The present disclosure is applicable to power supply modules.

### Description of the Reference Numerals

20: OBC board (drive board), 22: power converter (electronic circuit), 22a: heat-generating component (electronic component that generates a relatively small amount of heat), 22b: reactor (electronic component that generates a relatively large amount of heat), 22c: transformer (electronic component that generates a relatively large amount of heat), 23: metal base substrate (drive board), 30: motor drive board (drive board), 32: power converter (electronic circuit), 32a: heat-generating component (electronic component that generates a relatively large amount of heat), 43: film capacitor (electronic component that generates a relatively large amount of heat), 50: cooling case, 50a: lower case, 50b: upper case, 50c: first portion, 50d: second portion, 50e: joint, 50g: gap, 50h: air (gas), 50i: wall, 53: channel, 54: protrusion, 100: power supply module

## Claims

1. A power supply module comprising a cooling case facing a plurality of electronic components that generates different amounts of heat, and provided inside with a channel through which a cooling fluid flows, wherein the cooling case includes
a first portion facing the electronic component that generates a relatively large amount of heat, and
a second portion facing the electronic component that generates a relatively small amount of heat, the second portion having a lower thermal conductivity than the first portion.

2. The power supply module according to claim 1, wherein the plurality of electronic components constitutes an electronic circuit, and the electronic circuit is mounted on a drive board.

3. The power supply module according to claim 1 or 2, wherein the electronic component that generates a relatively large amount of heat is at least one of a reactor, a transformer, and a film capacitor.

4. The power supply module according to any one of claims 1 to 3, wherein the first portion is made of a material containing aluminum, and the second portion is made of a material containing resin.

5. The power supply module according to claim 4, wherein a joint provided by insert-molding the first portion into the second portion is present at a boundary between the first portion and the second portion.

6. The power supply module according to any one of claims 1 to 4, wherein the second portion includes a plurality of layers with a gap in between in which a gas having a lower thermal conductivity than the first portion is present.

7. The power supply module according to claim 6, wherein the gas is air.

8. The power supply module according to any one of claims 1 to 7, wherein the channel of the cooling case includes a plurality of protrusions.

9. The power supply module according to any one of claims 1 to 8, wherein
the cooling case includes an upper case and a lower case, and
the upper case or the lower case includes the first portion and the second portion.

10. The power supply module according to any one of claims 1 to 9, wherein the cooling case includes, between the electronic component that generates a relatively large amount of heat and the electronic component that generates a relatively small amount of heat, a wall made of a material contained in the second portion.
